(19) Europäisches Patentamt
European Patent Office
Office européen des brevets

(11) **EP 3 346 610 B1**

(12) # EUROPÄISCHE PATENTSCHRIFT

(45) Veröffentlichungstag und Bekanntmachung des Hinweises auf die Patenterteilung:
**07.08.2019   Patentblatt 2019/32**

(51) Int Cl.:
**H03L 7/091** *(2006.01)*    **G01R 19/25** *(2006.01)*

(21) Anmeldenummer: **18151321.9**

(22) Anmeldetag: **14.10.2015**

(54) **PROZESSOR ZUM BESTIMMEN EINER PHASE EINES EMPFANGSSIGNALS BASIEREND AUF EINER EMPFANGSSEQUENZ ABGETASTETER WERTE**

PROCESSOR FOR DETERMINING A PHASE OF A RECEIVED SIGNAL BASED ON VALUES SAMPLED FROM A RECEIVING SEQUENCE

PROCESSEUR PERMETTANT DE DÉTERMINER UNE PHASE D'UN SIGNAL DE RÉCEPTION EN FONCTION D'UNE VALEUR ÉCHANTILLONNÉE DE LA SÉQUENCE DE RÉCEPTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.10.2014   DE 102014015126**

(43) Veröffentlichungstag der Anmeldung:
**11.07.2018   Patentblatt 2018/28**

(62) Dokumentnummer(n) der früheren Anmeldung(en) nach Art. 76 EPÜ:
**15781337.9 / 3 207 635**

(73) Patentinhaber: **Sonovum AG**
**04103 Leipzig (DE)**

(72) Erfinder:
• **Wrobel, Miroslaw**
**97753 Karlstadt (DE)**
• **Kolany, Adam**
**04199 Leipzig (DE)**

(74) Vertreter: **advotec.**
**Patent- und Rechtsanwälte**
**Beethovenstrasse 5**
**97080 Würzburg (DE)**

(56) Entgegenhaltungen:
WO-A1-2010/045979    US-A- 5 404 388
US-A- 5 854 995    US-B1- 6 246 267

• SYED MASUD MAHMUD ED - INSTITUTE OF ELECTRICAL AND ELECTRONICS ENGINEERS: "PHASE MEASUREMENT ALGORITHM USIG ADAPTIVE SAMPLING", INSTRUMENTATION AND MEASUREMENT TECHNOLOGY CONFERENCE. WASHINGTON, APRIL 25 - 27, 1989; [PROCEEDINGS OF THE INSTRUMENTATION AND MEASUREMENT TECHNOLOGY CONFERENCE], NEW YORK, IEEE, US, Bd. CONF. 6, Nr. 1989, 25. April 1989 (1989-04-25), Seiten 219-222, XP000041365,

**Beschreibung**

Die vorliegende Erfindung betrifft einen Prozessor zum Bestimmen einer Phase eines Empfangssignals basierend auf einer Empfangssequenz abgetasteter Werte.

Die US 5 404 388 A beschreibt ein Phasendetektionsverfahren, wobei eine Empfangssequenz von mit einer Abtastfrequenz abgetasteten Werten eines Empfangssignals empfangen wird, und wobei das Empfangssignal eine Reaktion auf ein Sendesignal mit einer bekannten Sendefrequenz darstellt.

Die genaue Bestimmung der Phase eines Ausgangssignals am Ausgang eines Übertragungsmediums bei Anregung am Eingang mit einem Eingangssignal bekannter Frequenz ist für eine Vielzahl von Anwendungen von Bedeutung. Beispielsweise kann die Phaseninformation in Kodierverfahren der Nachrichtentechnik dazu genutzt werden, um Nachrichten in Form von elektrischen, magnetischen oder elektro-magnetischen Signalen über einen Kommunikationskanal zu übertragen. Im Bereich der Materialwissenschaften gibt die Messung der Phase einer akustischen Welle Aufschluss über die Materialeigenschaften des Übertragungsmediums. In chemischen und physikalischen Analysesystemen werden Phasendetektoren genutzt, um Temperatur, Dichte, Phasenänderungen chemischer Reaktionen, Objektdimensionen und Flüssigkeitskonzentration in chemischen und physikalischen Medien zu bestimmen. In medizinischen Diagnostizierverfahren werden Eigenschaften von Geweben durch Messung der Phase von eingekoppelten akustischen und Ultraschall-Signalen ermittelt. Anwendungen hierzu sind die Überwachung der Blutzirkulation im Körper zur Erkennung krankhafter Zustände, insbesondere im Gehirn, und die Mammasonographie.

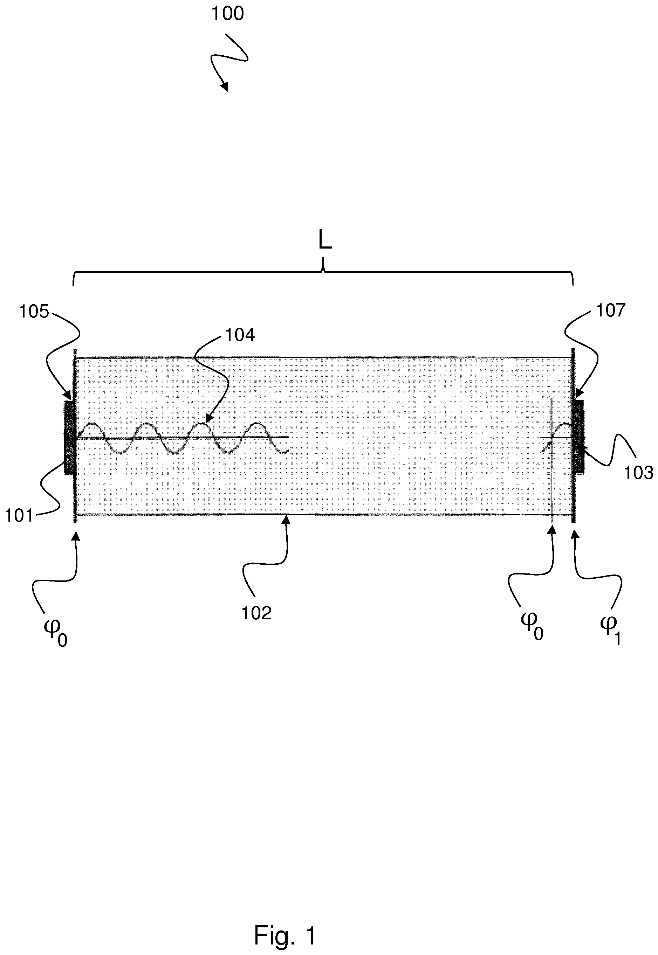

Fig. 1 zeigt eine schematische Darstellung eines Systems 100 zur Messung von Phasenbeziehungen akustischer Wellen in einem Gefäß 102. Das System 100 umfasst ein zu messendes Gefäß 102, beispielsweise eine Körperzelle, ein Blutgefäß oder eine Ader mit einer Gefäßlänge L und einen Sender 101 und Empfänger 103 von Ultraschallwellen. Der Sender 101 koppelt eine Ultraschallwelle 104 einer bekannten Frequenz $f_0$ mit Phase $\varphi_0$ an einem Eingang 105 des Gefäßes 102 in das Gefäß 102 ein, wo sie sich ausbreitet und am Ausgang 107 von dem Empfänger 103 empfangen wird. Wie aus Fig. 1 zu sehen ist, weist die Ultraschallwelle 104 in dem Gefäß 102 eine ganzzahlige Anzahl von Schwingungsperioden P auf sowie eine Teilperiode, die als Phasendifferenz $\varphi_1 - \varphi_0$ dargestellt werden kann. Zwischen der Laufzeit $T_p$ der akustischen Welle 104 und der Phasendifferenz $\varphi_1 - \varphi_0$ gilt die folgende Beziehung:

$$2\pi \cdot f_0 T_P = 2\pi P + (\varphi_1 - \varphi_0) \tag{1}$$

Für die Phasengeschwindigkeit $V$ in dem Gefäß 102 gilt einerseits die Beziehung

$$V = \lambda \cdot f_0 \ , \tag{2}$$

wobei $f_0$ die bekannte Sendefrequenz und $\lambda$ die Wellenlänge im Gefäß 102 bezeichnet.
Andererseits gilt für die Phasengeschwindigkeit $V$ in dem Gefäß 102 die Beziehung

$$V = \sqrt{\frac{K}{\rho}} \ , \tag{3}$$

wobei $K$ die Elastizität des Gefäßes und $\rho$ seine Dichte angibt. Aus der Phasengeschwindigkeit $V$ lassen sich somit die Eigenschaften des Gefäßes 102 bestimmen. Die Wellenlänge $\lambda$ lässt sich aus der Anzahl der Perioden $P$ und der Phasendifferenz $\varphi_1 - \varphi_0$ bestimmen und mittel der bekannten Sendefrequenz $f_0$ lässt sich die Phasengeschwindigkeit $V$ ermitteln, mit der sich die Materialeigenschaften des Gefäßes 102 charakterisieren lassen.

Üblicherweise wird zum Bestimmen der Phasendifferenz $\varphi_1 - \varphi_0$ der Empfänger mit dem Sender synchronisiert und über einen Analog-Digitalwandler das empfangene Signal abgetastet. Der Abtastwert des empfangenen Signals kann mit dem Synchronisationszeitpunkt in Beziehung gesetzt werden und daraus lässt sich die Phasendifferenz bestimmen.

Allerdings ist die Messgenauigkeit von einer Vielzahl an Systemparametern abhängig, wie beispielsweise der Genauigkeit der Abtastung, der Genauigkeit der Frequenzeinstellung des Sendesignals, Genauigkeit der Einkopplung und Auskopplung des akustischen Signals, Interferenzen des Sendesignals aufgrund Reflektionen an den Gefäßenden und Gefäßseiten, Dopplereffekten etc.

Es ist die Aufgabe der vorliegenden Erfindung, ein Konzept für eine einfache und präzise Bestimmung der Phase am Ausgang eines Übertragungsmediums bei Anregung mit einem Sendesignal bekannter Signalcharakteristik zu schaffen.

Diese Aufgabe wird durch die Merkmale der unabhängigen Ansprüche gelöst. Vorteilhafte Weiterbildungsformen sind Gegenstand der abhängigen Ansprüche.

Die im Folgenden vorgestellten Vorrichtungen und Systeme können von verschiedener Art sein. Die einzelnen beschriebenen Elemente können durch Hardware- oder Softwarekomponenten realisiert sein, beispielsweise elektronische Komponenten, die durch verschiedene Technologien hergestellt werden können und zum Beispiel Halbleiterchips, ASICs, Mikroprozessoren, digitale Signalprozessoren, integrierte elektrische Schaltungen, elektrooptische Schaltungen und/oder passive Bauelemente umfassen.

Die Erfindung betrifft einen Prozessor zum Bestimmen einer Phase eines Empfangssignals, mit: einem Eingangsregister, das ausgelegt ist, einen Empfangswert eines mit bekannter Abtastfrequenz $f_S$ abgetasteten Empfangssignals zu speichern, wobei das Empfangssignal eine Reaktion auf ein Sendesignal mit einer bekannten Sendefrequenz $f_W$ darstellt; ein erstes und zweites Koeffizientenregister, die ausgelegt sind, einen ersten und einen zweiten Fourier-Koeffizienten zu speichern, wobei der erste Fourier-Koeffizient eine lineare Beziehung zwischen dem Empfangssignal und einem Phasenrealteil des Empfangssignals angibt und der zweite Fourier-Koeffizient eine lineare Beziehung zwischen dem Empfangssignal und einem Phasenimaginärteil des Empfangssignals angibt; einem ersten und zweiten Ausgangsregister, die ausgelegt sind, einen Phasenrealteil und einen Phasenimaginärteil des Empfangssignals bereitzustellen; und einer Recheneinheit, die ausgelegt ist, den Phasenrealteil des Empfangssignals basierend auf einem gemittelten Produkt des Empfangswertes mit dem Inhalt des ersten Koeffizientenregisters zu bestimmen und den Phasenimaginärteil des Empfangssignals basierend auf einem gemittelten Produkt des Empfangswertes mit dem Inhalt des zweiten Koeffizientenregisters zu bestimmen.

Dies hat den Vorteil, dass ein solcher Prozessor die Phase am Ausgang eines Übertragungsmediums bei Anregung mit einem Sendesignal bekannter Signalcharakteristik einfach und präzise bestimmen kann. Bei bekannter Sendefrequenz und Abtastfrequenz kann der Prozessor die beiden Skalarprodukte mit geringem Aufwand bestimmen und präzise Werte für die Phase des Empfangssignals liefern.

Gemäß einer Ausführungsform umfasst der Prozessor eine Instruktionseinheit, die ausgelegt ist, ansprechend auf ein Reset-Signal das zweite Koeffizientenregister auf Eins zu setzen und die restlichen Register zu löschen; ansprechend auf ein Takt-Signal einen neuen Empfangswert des abgetasteten Empfangssignals zu speichern und das erste und zweite Koeffizientenregister mit neuen Koeffizienten zu versorgen.

Dies hat den Vorteil, dass der Prozessor abhängig von dem Taktsignal das Eingangssignal einlesen kann und in jedem Takt einen neuen Verarbeitungsschritt durchführen kann. Die Verarbeitung kann ja nach Takt sehr schnell und mit geringem Aufwand erfolgen.

Gemäß einer Ausführungsform des Prozessors ist die Recheneinheit ausgelegt, die gemittelten Produkte basierend auf einer zeitlichen Mittelung der abhängig von dem Taktsignal jeweils vorliegenden Produkte aus dem Empfangswert und dem Inhalt des ersten Koeffizientenregisters bzw. dem Inhalt des zweiten Koeffizientenregisters zu bestimmen.

Dies hat den Vorteil, dass der Prozessor die jeweils vorliegenden Produkte in jedem Takt weiterverarbeiten kann. Das am Ende vorliegende Ergebnis lässt sich somit unter Nutzung der Teilergebnisse, d.h. der jeweils vorliegenden Produkte, effizient berechnen.

Gemäß einer Ausführungsform des Prozessors ist die Instruktionseinheit ausgelegt, ansprechend auf das Takt-Signal das zweite Koeffizientenregister mit dem Koeffizienten $dC \cdot C - dS \cdot S$ zu erneuern und das erste Koeffizientenregister mit dem Koeffizienten $dC \cdot S + dS \cdot C$ zu erneuern, wobei C den Inhalt des zweiten Koeffizientenregisters, S den Inhalt des ersten Koeffizientenregister angibt und ferner gilt: $dC = \cos(\Omega)$ und $dS = \sin(\Omega)$ mit $\Omega = 2\pi^*(f_W/f_S)$.

Dies hat den Vorteil, dass sich die Kovarianzen der einzelnen Sequenzen schrittweise bestimmen lassen, so dass sich der Rechenaufwand auf die einzelnen Takte aufteilen lässt. Die Phase des Empfangssignals lässt sich damit aufwandseffizient und präzise bestimmen.

Gemäß einer Ausführungsform umfasst der Prozessor ein erstes und zweites internes Register; und die Instruktionseinheit ist ausgelegt, ansprechend auf das Takt-Signal das erste interne Register mit einem Produkt aus dem Inhalt des Eingangsregisters und dem Inhalt des ersten Koeffizientenregisters zu inkrementieren und das zweite interne Register mit einem Produkt aus dem Inhalt des Eingangsregisters und dem Inhalt des zweiten Koeffizientenregisters zu inkrementieren und jeweils mit einem Normierungsfaktor normiert in dem ersten beziehungsweise zweiten Ausgangsregister bereitzustellen.

Dies hat den Vorteil, dass sich die Phase des Empfangssignals schrittweise bestimmen lässt und der Rechenaufwand somit auf die einzelnen Takte des Taktsignals verteilt wird.

Gemäß einer Ausführungsform umfasst der Prozessor ein drittes Ausgangsregister, das ausgelegt ist, einen Bias des Empfangssignals bereitzustellen; und die Recheneinheit ist ausgelegt, den Bias des Empfangssignals basierend auf einer zeitlichen Mittelung des Inhalts des Eingangsregisters zu bestimmen.

Dies hat den Vorteil, dass der Prozessor den Bias bzw. Offset des Empfangssignals auf einfache Weise durch zeitliche Mittelung des Inhalts des Eingangsregisters bestimmen kann.

Die Bestimmung der Phase und des Bias nach den hier beschriebenen Aspekten und Ausführungsbeispielen sind für eine Vielzahl von Anwendungen von Bedeutung. Beispielsweise kann die so bestimmte Phase bzw. der so bestimmte Bias in Kodierverfahren der Nachrichtentechnik dazu genutzt werden, um Nachrichten in Form von elektrischen, magnetischen oder elektro-magnetischen Signalen über einen Kommunikationskanal zu übertragen. Im Bereich der Materialwissenschaften kann die so bestimmte Phase bzw. der so bestimmte Bias in Bezug auf eine akustische Welle Aufschluss über die Materialeigenschaften des Übertragungsmediums geben. In chemischen und physikalischen Analysesystemen kann die so bestimmte Phase bzw. der so bestimmte Bias dazu genutzt werden, um Temperatur, Dichte, Phasenänderungen chemischer Reaktionen, Objektdimensionen und Flüssigkeitskonzentration in chemischen und physikalischen Medien zu bestimmen.

In medizinischen Diagnostizierverfahren kann bei eingekoppelten akustischen und Ultraschall- Signalen die nach den hier beschriebenen Aspekten und Ausführungsbeispielen bestimmte Phase bzw. Bias dazu genutzt werden, um Eigenschaften von Geweben zu ermitteln. Ausführungsbeispiele der Erfindung finden Anwendung beispielsweise bei der Überwachung der Blutzirkulation im Körper zur Erkennung krankhafter Zustände, insbesondere im Gehirn, und in der Mammasonographie. Die Phaseninformation kann hier Aufschluss geben sowohl über einen gesunden Zustand als auch einen kranken Zustand des Gewebes. Beispielsweise können mittels Messungen der Phase nach den hier vorgestellten Verfahren bzw. mit den hier vorgestellten Prozessoren an gesunden Patienten Informationen über einen gesunden Zustand des Gewebes gewonnen werden, die als eine Art Referenzwert dienen können. Bei Messungen an Patienten, bei denen die Phaseninformation gegenüber dem ermittelten Referenzwert abweicht, kann auf einen krankhaften Zustand des Patienten geschlossen werden.

Weitere Ausführungsbeispiele werden Bezug nehmend auf die beiliegenden Zeichnungen erläutert. Es zeigen:

Fig. 1 eine schematische Darstellung eines Systems 100 zur Messung von Phasenbeziehungen akustischer Wellen in einem Gefäß 102;

Fig. 2 eine schematische Darstellung eines Phasendetektionsverfahrens 200 gemäß einer Ausführungsform;

Fig. 3 eine schematische Darstellung eines Prozessors 300 zum Bestimmen einer Phase eines Empfangssignals gemäß einer ersten Ausführungsform;

Fig. 4 eine schematische Darstellung eines Prozessors 400 zum Bestimmen einer Phase eines Empfangssignals gemäß einer zweiten Ausführungsform; und

Fig. 5 eine schematische Darstellung eines Prozessors 500 zum Bestimmen einer Phase eines Empfangssignals gemäß einer dritten Ausführungsform.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

Wenngleich ein bestimmtes Merkmal oder ein bestimmter Aspekt einer Ausführungsform bezüglich nur einer von mehreren Implementierungen offenbart worden sein mag, kann außerdem ein derartiges Merkmal oder ein derartiger Aspekt mit einem oder mehreren anderen Merkmalen oder Aspekten der anderen Implementierungen kombiniert werden, wie für eine gegebene oder bestimmte Anwendung erwünscht und vorteilhaft sein kann. Weiterhin sollen in dem Ausmaß, in dem die Ausdrücke "enthalten", "haben", "mit" oder andere Varianten davon entweder in der ausführlichen Beschreibung oder den Ansprüchen verwendet werden, solche Ausdrücke auf eine Weise ähnlich dem Ausdruck "umfassen" einschließend sein. Die Ausdrücke "gekoppelt" und "verbunden" können zusammen mit Ableitungen davon verwendet worden sein. Es versteht sich, dass derartige Ausdrücke dazu verwendet werden, um anzugeben, dass zwei Elemente unabhängig davon miteinander kooperieren oder interagieren, ob sie in direktem physischem oder elektrischem Kontakt stehen oder nicht in direktem Kontakt miteinander stehen. Außerdem ist der Ausdruck "beispielhaft" lediglich als ein Beispiel aufzufassen anstatt der Bezeichnung für das Beste oder Optimale. Die folgende Beschreibung ist deshalb nicht in einem einschränkenden Sinne zu verstehen.

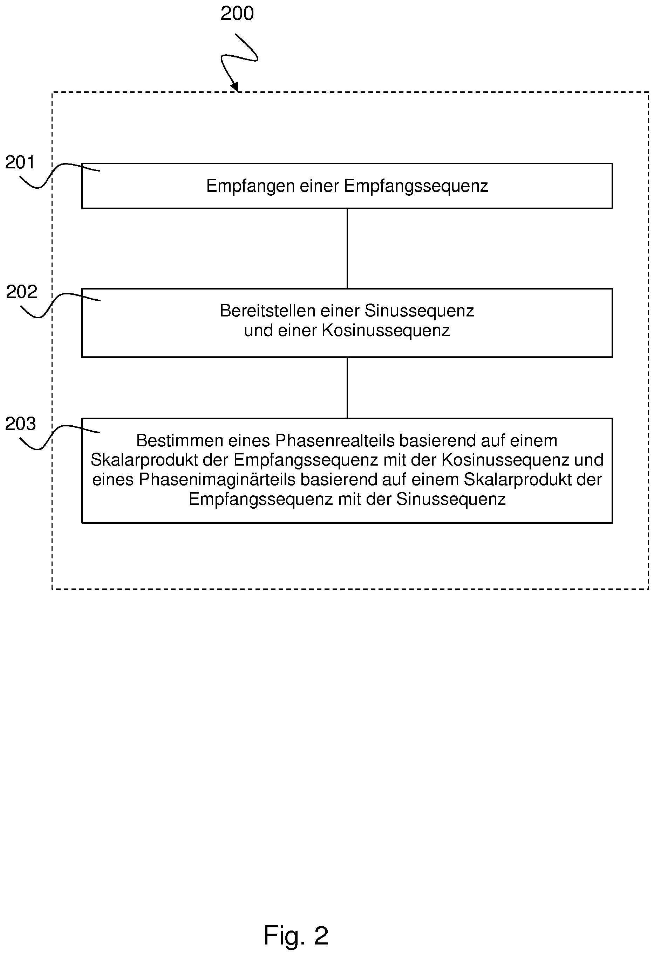

Fig. 2 zeigt eine schematische Darstellung eines Phasendetektionsverfahrens 200 gemäß einer Ausführungsform. Das Verfahren 200 umfasst ein Empfangen 201 einer Empfangssequenz $Y_j$ von mit bekannter Abtastfrequenz $f_S$ abgetasteten Werten $Y_0$, $Y_1$, ..., $Y_{N-1}$ eines Empfangssignals Y, wobei das Empfangssignal Y eine Reaktion auf ein Sendesignal mit einer bekannten Sendefrequenz $f_w$ darstellt. Das Verfahren 200 umfasst ein Bereitstellen 202 einer Sinussequenz $S_j$ und einer Kosinussequenz $C_j$ für jeden Index j der Empfangssequenz $Y_j$, die Sinussequenz $S_j$ umfassend Sinuswerte aufeinanderfolgender Vielfacher einer bekannten Kreisfrequenz, welche von der Sendefrequenz $f_w$ und der Abtastfrequenz $f_s$ abhängt, und die Kosinussequenz $C_j$ umfassend Kosinuswerte aufeinanderfolgender Vielfacher der bekannten Kreisfrequenz. Das Verfahren 200 umfasst ein Bestimmen 203 eines Phasenrealteils U des Empfangssignals Y basierend auf einem Skalarprodukt der Empfangssequenz $Y_j$ mit der Kosinussequenz $C_j$ und eines Phasenimaginärteils V des Empfangssignals basierend auf einem Skalarprodukt der Empfangssequenz $Y_j$ mit der Sinussequenz $S_j$.

Die bekannte Kreisfrequenz $\Omega$ kann der Beziehung $\Omega = 2\pi(f_w/f_s)$ genügen.
Ein Normierungsfaktor 2/N der beiden Skalarprodukte kann abhängig von einer Länge N der Empfangssequenz $Y_j$ sein. Die Abtastfrequenz $f_S$, mit der das Empfangssignal Y abgetastet wird, kann unabhängig von dem Nyquist-Shannon Abtasttheorem sein. Die Länge N der Empfangssequenz $Y_j$ multipliziert mit einem Quotienten aus bekannter Sendefrequenz $f_w$ und der bekannten Abtastfrequenz $f_s$ kann ganzzahlig sein und eine Periode sowohl der Kosinussequenz $C_j$ als auch der Sinussequenz $S_j$ sein. Die Länge N der Empfangssequenz $Y_j$ kann einem Quotienten aus der Abtastfrequenz $f_s$ und dem kleinsten gemeinsamen Nenner aus der Abtastfrequenz $f_s$ und der Sendefrequenz $f_w$ oder einem Vielfachen des Quotienten entsprechen.

Die folgende Darstellung beschreibt die theoretischen Grundlagen des Verfahrens 200.

Gegeben sei ein Vektor

$$Y_0, Y_1, ..., Y_{N-1} \qquad (4)$$

von abgetasteten Werten der Funktion

$$Y(\tau) = \beta + A\sin(2\pi \cdot f_w \tau + \varphi) \qquad (5)$$

bei der Abtastfrequenz $f_s$.

Die Näherungswerte der unbekannten Parameter
$A, \beta$ und $\varphi$
können zurückgewonnen werden durch Anwendung eines Least Squares Verfahrens (Verfahren der kleinsten Quadrate) unter Nutzung der folgenden Formeln:

$$\begin{bmatrix} Cov(S,Y) \\ Cov(C,Y) \end{bmatrix} = \begin{bmatrix} Cov(S,S) & Cov(S,C) \\ Cov(C,S) & Cov(C,C) \end{bmatrix} \times \begin{bmatrix} A\cos(\varphi) \\ A\sin(\varphi) \end{bmatrix}, \qquad (6a)$$

$$\beta = \overline{Y} - A \cdot (\overline{C}\sin(\varphi) + \overline{S}\cos(\varphi)), \qquad (6b)$$

wobei der Term

$$Cov(Z,T) = \overline{(Z-\overline{Z}) \cdot (T-\overline{T})} = \overline{ZT} - \overline{Z} \cdot \overline{T} \qquad (7)$$

eine Kovarianz der Sequenzen Z und T
und der Sequenzen S und C darstellt, und
wobei S und C gegeben sind durch die Beziehungen:

$$S_j = \sin(2\pi \cdot (f_w / f_s) \cdot j), \quad j = 0,...,N-1 \qquad (8a)$$

$$C_j = \cos(2\pi \cdot (f_w / f_S) \cdot j), \quad j = 0, \ldots, N-1 \qquad (8b)$$

Wie leicht zu sehen ist, ist für jedes N der Term

$$N \cdot (f_w / f_S) \in \mathbb{Z}, \qquad (9)$$

eine Periode von beiden Sequenzen $\{S_j\}$ und $\{C_j\}$, wobei Z die Menge der ganzen Zahlen bezeichnet.

Dann ist auch N eine Vielfaches von

$$\hat{f}_S = \frac{f_S}{ggT(f_S, f_w)}, \qquad (10)$$

wobei ggT den größten gemeinsamen Teiler bezeichnet und es gilt:

$$\overline{S} = \frac{1}{N} \cdot \sum_{j=0}^{N-1} S_j = 0, \quad \overline{C} = \frac{1}{N} \cdot \sum_{j=0}^{N-1} C_j = 0, \quad \overline{SC} = \frac{1}{N} \cdot \sum_{j=0}^{N-1} S_j C_j = 0 \qquad (11a)$$

$$\overline{S^2} = \frac{1}{N} \cdot \sum_{j=0}^{N-1} S_j^2 = \frac{1}{2} \text{ und } \overline{C^2} = \frac{1}{N} \cdot \sum_{j=0}^{N-1} C_j^2 = \frac{1}{2}. \qquad (11b)$$

Die Gleichung (6a) nimmt damit die folgende Form an:

$$\begin{bmatrix} \overline{S \cdot Y} \\ \overline{C \cdot Y} \end{bmatrix} = \begin{bmatrix} \frac{1}{2} & 0 \\ 0 & \frac{1}{2} \end{bmatrix} \times \begin{bmatrix} A\cos(\varphi) \\ A\sin(\varphi) \end{bmatrix} \qquad (12)$$

Somit gilt:

$$U = A\cos(\varphi) = 2 \cdot \overline{SY}, \qquad (13a)$$

$$V = A\sin(\varphi) = 2 \cdot \overline{CY} \qquad (13b)$$

und die gesuchten Werte können über die folgenden Beziehungen bestimmt werden:

$$A = \sqrt{U^2 + V^2}, \qquad (14a)$$

$$\varphi = (\arcsin(V / A) \bmod 2\pi), \qquad (14b)$$

$$\beta = \overline{Y}. \qquad (14c)$$

Das Empfangen 201 der Empfangssequenz $Y_j$ von mit bekannter Abtastfrequenz $f_S$ abgetasteten Werten $Y_0$, $Y_1$, ..., $Y_{N-1}$ eines Empfangssignals Y des Verfahrens 200 lässt sich mit den Gleichungen (4) und (5) beschreiben.

Das Bereitstellen 202 einer Sinussequenz $S_j$ und einer Kosinussequenz $C_j$ für jeden Index j der Empfangssequenz $Y_j$ des Verfahrens 200 lässt sich durch die Gleichungen (8a), (8b), (9) und (10) beschreiben.

Das Bestimmen 203 eines Phasenrealteils U des Empfangssignals Y basierend auf einem Skalarprodukt der

Empfangssequenz $Y_j$ mit der Kosinussequenz $C_j$ und eines Phasenimaginärteils V des Empfangssignals basierend auf einem Skalarprodukt der Empfangssequenz $Y_j$ mit der Sinussequenz $S_j$ des Verfahrens 200 lässt sich durch die Gleichungen (6a), (6b), (7) und (11a) bis (14c) beschreiben.

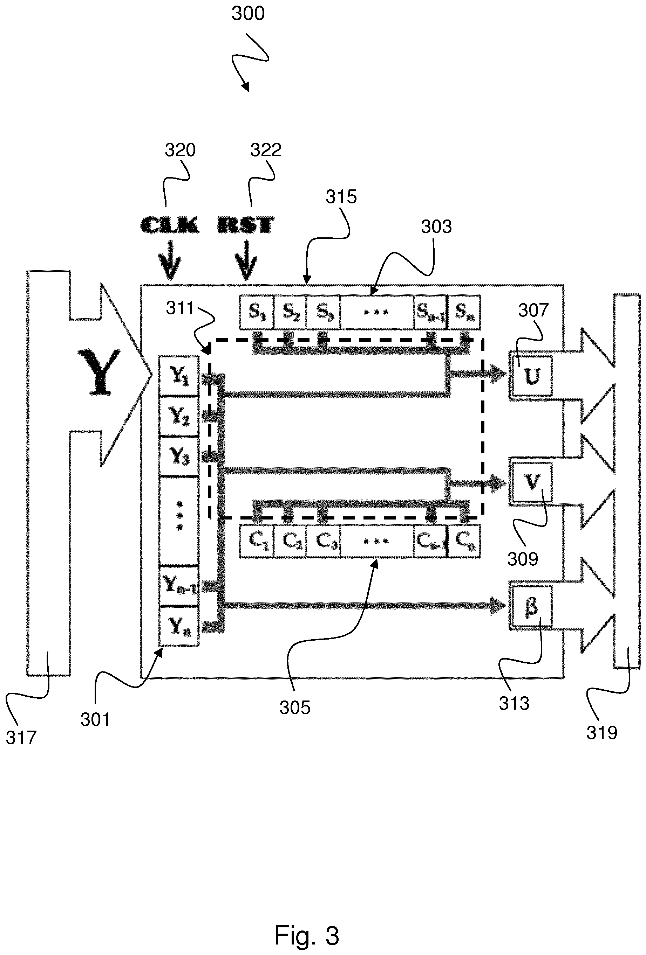

Fig. 3 zeigt eine schematische Darstellung eines Prozessors 300 zum Bestimmen einer Phase eines Empfangssignals gemäß einer ersten Ausführungsform.

Der Prozessor 300 umfasst ein N-stufiges Eingangsregister 301, ein N-stufiges erstes Parameterregister 303, ein N-stufiges zweites Parameterregister 305, ein erstes Ausgangsregister 307, ein zweites Ausgangsregister 309, ein drittes Ausgangsregister 313, eine Recheneinheit 311 und eine Instruktionseinheit 315. Der Prozessor 300 umfasst ferner einen Eingang für ein Taktsignal CLK 320 und einen Eingang für ein Reset-Signal RST 322. Der Prozessor 300 ist eingangsseitig mit einem Eingangsdatenbus 317 und ausgangsseitig mit einem Ausgangsdatenbus 319 gekoppelt.

Das N-stufige Eingangsregister 301 ist ausgelegt, eine Empfangssequenz $Y_j$ von mit bekannter Abtastfrequenz $f_S$ abgetasteten Werten $Y_0$, $Y_1$, ..., $Y_{N-1}$ des Empfangssignals Y zu speichern, wobei das Empfangssignal Y eine Reaktion auf ein Sendesignal mit einer bekannten Sendefrequenz $f_w$ darstellt.

Das N-stufige erste Parameterregister 303 ist ausgelegt, eine Sinussequenz $S_j$ zu speichern, die Sinuswerte aufeinanderfolgender Vielfacher einer bekannten Kreisfrequenz $\Omega$, die von der Sendefrequenz $f_w$ und der Abtastfrequenz $f_s$ abhängt, umfasst. Das N-stufige zweite Parameterregister 305 ist ausgelegt, eine Kosinussequenz $C_j$ zu speichern, die Kosinuswerte aufeinanderfolgender Vielfacher der bekannten Kreisfrequenz $\Omega$ umfasst.

Die bekannte Kreisfrequenz $\Omega$ kann der Beziehung $\Omega = 2\pi(f_w/f_s)$ genügen.

Das erste Ausgangsregister 307 ist ausgelegt, einen Phasenrealteil U des Empfangssignals bereitzustellen. Das zweite Ausgangsregister 309 ist ausgelegt, einen Phasenimaginärteil V des Empfangssignals bereitzustellen.

Die Recheneinheit 311 ist ausgelegt, den Phasenrealteil U des Empfangssignals Y basierend auf einem Skalarprodukt der Empfangssequenz $Y_j$ mit der Sinussequenz $S_j$ zu bestimmen. Die Recheneinheit 311 ist ferner ausgelegt, den Phasenimaginärteil V des Empfangssignals Y basierend auf einem Skalarprodukt der Empfangssequenz $Y_j$ mit der Kosinussequenz $C_j$ zu bestimmen. Ein Normierungsfaktor der beiden Skalarprodukte kann als 2/N gewählt werden, wobei N eine Länge der Empfangssequenz $Y_j$ angibt.

Die Recheneinheit 311, die hier nur als gestrichelter Kasten angedeutet ist, kann arithmetisch-logische Einheiten zum Ausführen arithmetischer Operationen aufweisen. Sie kann Addierer, Multiplizierer und weitere Einheiten zum Ausführen von Rechenoperationen aufweisen.

Das dritte Ausgangsregister 313 ist ausgelegt, einen Bias des Empfangssignals Y bereitzustellen, der von der Recheneinheit 311 basierend auf einem Mittelwert der Empfangssequenz $Y_j$ bestimmt werden kann.

Der Prozessor 300 kann in Hardware oder in Software realisiert sein. Der Prozessor 300 kann eine Operationseinheit auf einem Chip bilden oder als Chip realisiert sein. Der Prozessor 300 kann ein digitaler Signalprozessor oder ein Mikrocontroller sein. Der Prozessor 300 kann als FPGA, als integrierte Schaltung, als ASIC oder als Teil dieser Bauelemente realisiert sein. Der Prozessor 300 kann in einem Empfänger oder als Teil einer Empfängerschaltung realisiert sein, beispielsweise einem Empfänger 103 wie in Figur 1 dargestellt.

Die Funktionsweise des Prozessors 300 kann wie folgt beschrieben werden.

Die in den beiden Parameterregistern 303, 305 gespeicherten Vektoren S und C enthalten jeweils die Sequenzen:

$$\sin(2\pi\sigma \cdot j) , \quad j = 0,...,N-1 \text{ und} \qquad\qquad (15a)$$

$$\cos(2\pi\sigma \cdot j) , \quad j = 0,...,N-1 , \qquad\qquad (15b)$$

wobei $\sigma$ einen Quotienten aus der Signalfrequenz $f_w$ und der Abtastfrequenz $f_s$ bezeichnet:

$$\sigma = \frac{f_w}{f_s} = \frac{\hat{f}_w}{\hat{f}_s} \qquad\qquad (16)$$

Nach Einschalten des Prozessors 300 bzw. nach Empfang des Reset-Signals RST 322 werden Daten vom Eingangsdatenbus 317 in das N-stufige Eingangsregister 301 übertragen. Die Ausgangsregister U und V werden jeweils mit den Werten

$$\frac{2}{N} Y \circ S \quad \text{und} \tag{17a}$$

$$\frac{2}{N} Y \circ C \tag{17b}$$

geladen, wobei Y die Sequenz abgetasteter Werte $Y_0$, $Y_1$, ..., $Y_{N-1}$ des Empfangssignals Y in Vektorform darstellt und S und C jeweils die Sinussequenz $S_j$ bzw. Kosinussequenz $C_j$ in Vektorform darstellt. Das Symbol $\circ$ bezeichnet das Skalarprodukt bzw. das innere Produkt zweier Vektoren.

Der Bias $\beta$ kann gemäß der folgenden Beziehung als Mittelwert über die Sequenz abgetasteter Werte $Y_0$, $Y_1$, ..., $Y_{N-1}$ des Empfangssignals Y bestimmt werden:

$$\overline{Y} = \frac{1}{N} \sum_{j=1...N} Y_j \tag{18}$$

und wird im dritten Ausgangsregister 313 gespeichert.

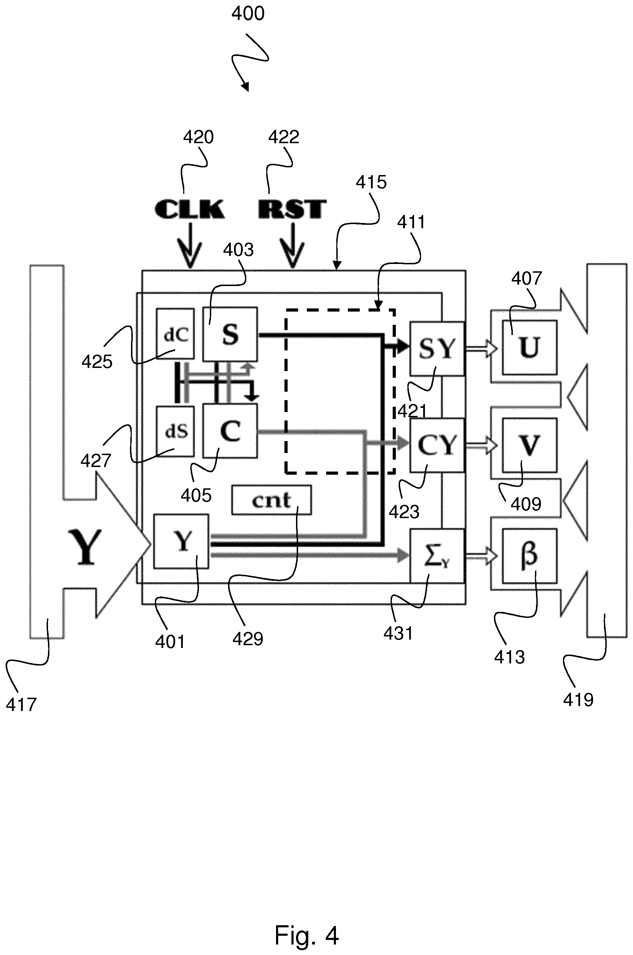

Fig. 4 zeigt eine schematische Darstellung eines Prozessors 400 zum Bestimmen einer Phase eines Empfangssignals gemäß einer zweiten Ausführungsform.

Der Prozessor 400 umfasst ein Eingangsregister 401, ein erstes Parameterregister 403, ein zweites Parameterregister 405, ein drittes Parameterregister 425, ein viertes Parameterregister 427, einen Zähler 429, ein erstes Ausgangsregister 407, ein zweites Ausgangsregister 409, ein drittes Ausgangsregister 413, ein erstes internes Register 421, ein zweites internes Register 423, ein drittes internes Register 431, eine Recheneinheit 411 und eine Instruktionseinheit 415. Der Prozessor 311 umfasst ferner einen Eingang für ein Taktsignal CLK 420 und einen Eingang für ein Reset-Signal RST 422. Der Prozessor 400 ist eingangsseitig mit einem Eingangsdatenbus 417 und ausgangsseitig mit einem Ausgangsdatenbus 419 gekoppelt.

Das Eingangsregister 401 ist ausgelegt, einen Empfangswert eines mit bekannter Abtastfrequenz $f_S$ abgetasteten Empfangssignals Y zu speichern, wobei das Empfangssignal Y eine Reaktion auf ein Sendesignal mit einer bekannten Sendefrequenz $f_W$ darstellt.

Das erste Koeffizientenregister 403 ist ausgelegt, einen ersten Fourier-Koeffizienten S zu speichern, der eine lineare Beziehung zwischen dem Empfangssignal Y und einem Phasenrealteil des Empfangssignals Y angibt.

Das zweite Koeffizientenregister 405 ist ausgelegt, einen zweiten Fourier-Koeffizienten C zu speichern, der eine lineare Beziehung zwischen dem Empfangssignal Y und einem Phasenimaginärteil des Empfangssignals Y angibt.

Das erste Ausgangsregister 407 ist ausgelegt, einen Phasenrealteil U des Empfangssignals Y bereitzustellen. Das zweite Ausgangsregister 409 ist ausgelegt, einen Phasenimaginärteil V des Empfangssignals Y bereitzustellen.

Die Recheneinheit 411 ist ausgelegt, den Phasenrealteil U des Empfangssignals Y basierend auf einem gemittelten Produkt des Empfangswertes mit dem Inhalt S des ersten Koeffizientenregisters 403 zu bestimmen. Die Recheneinheit 411 ist ausgelegt, den Phasenimaginärteil V des Empfangssignals Y basierend auf einem gemittelten Produkt des Empfangswertes mit dem Inhalt C des zweiten Koeffizientenregisters 405 zu bestimmen.

Die Recheneinheit 411, die hier nur als gestrichelter Kasten angedeutet ist, kann arithmetisch-logische Einheiten zum Ausführen arithmetischer Operationen aufweisen. Sie kann Addierer, Multiplizierer und weitere Einheiten zum Ausführen von Rechenoperationen aufweisen.

Die Instruktionseinheit 415 ist ausgelegt, ansprechend auf ein Reset-Signal 422 das zweite Koeffizientenregister 405 auf Eins zu setzen und die restlichen Register zu löschen. Die Instruktionseinheit 415 ist ausgelegt, ansprechend auf ein Takt-Signal 420 einen neuen Empfangswert des abgetasteten Empfangssignals Y zu speichern und das erste 403 und zweite 405 Koeffizientenregister mit neuen Koeffizienten S, C zu versorgen.

Die Recheneinheit 411 ist ferner ausgelegt, die gemittelten Produkte basierend auf einer zeitlichen Mittelung der abhängig von dem Taktsignal 420 jeweils vorliegenden Produkte aus dem Empfangswert und dem Inhalt S des ersten Koeffizientenregisters 403 bzw. dem Inhalt C des zweiten Koeffizientenregisters 405 zu bestimmen.

Die Instruktionseinheit 415 ist ausgelegt, ansprechend auf das Takt-Signal 420 das zweite Koeffizientenregister 405 mit dem Koeffizienten $dC \cdot C - dS \cdot S$ zu erneuern und das erste Koeffizientenregister 403 mit dem Koeffizienten $dC \cdot S + dS \cdot C$ zu erneuern. Hierbei gibt C den Inhalt des zweiten Koeffizientenregisters 405 an, S gibt den Inhalt des ersten Koeffizientenregister 403 an. Ferner gilt: $dC = \cos(\Omega)$ und $dS = \sin(\Omega)$ mit $\Omega = 2\pi \cdot (f_W/f_S)$. Die Werte dC und dS liegen jeweils in dem dritten Parameterregister 425 bzw. dem vierten Parameterregister 427 vor. Das Zählerregister 429 kann einen Zähler speichern zum Abzählen der Mittelwerte der gemittelten Produkte von Y mit S bzw. Y mit C.

Die Instruktionseinheit 415 ist ausgelegt, ansprechend auf das Takt-Signal 420 das erste interne Register 421 mit einem Produkt SY aus dem Inhalt des Eingangsregisters 401 und dem Inhalt S des ersten Koeffizientenregisters 403 zu inkrementieren. Die Instruktionseinheit 415 ist ausgelegt, ansprechend auf das Takt-Signal 420 das zweite interne Register 423 mit einem Produkt CY aus dem Inhalt des Eingangsregisters 401 und dem Inhalt C des zweiten Koeffizientenregisters 405 zu inkrementieren. Die Instruktionseinheit 415 ist ausgelegt, die jeweiligen Produkte mit einem Normierungsfaktor normiert in dem ersten 407 beziehungsweise zweiten 409 Ausgangsregister bereitzustellen.

Das dritte Ausgangsregister 413 ist ausgelegt, einen Bias $\beta$ des Empfangssignals Y bereitzustellen. Die Recheneinheit 411 ist ferner ausgelegt, den Bias $\beta$ des Empfangssignals Y basierend auf einer zeitlichen Mittelung des Inhalts des Eingangsregisters 401 zu bestimmen.

Der Prozessor 400 kann in Hardware oder in Software realisiert sein. Der Prozessor 400 kann eine Operationseinheit auf einem Chip bilden oder als Chip realisiert sein. Der Prozessor 400 kann ein digitaler Signalprozessor oder ein Mikrocontroller sein. Der Prozessor 400 kann als FPGA, als integrierte Schaltung, als ASIC oder als Teil dieser Bauelemente realisiert sein. Der Prozessor 400 kann in einem Empfänger oder als Teil einer Empfängerschaltung realisiert sein, beispielsweise einem Empfänger 103 wie in Figur 1 dargestellt.

Die Funktionsweise des Prozessors 400 kann wie folgt beschrieben werden.

Nach Einschalten des Prozessors 400 bzw. nach Empfang des Reset-Signals RST 422 wird der Prozessor mit der vorgegebenen Sendefrequenz $f_w$ und der vorgegebenen Abtastfrequenz $f_s$ betrieben. Der Zähler 429 wird entsprechend der Werte von $f_w$ und $f_s$ gesetzt. In einem Ausführungsbeispiel des Prozessors 400 wird die oben genannte Beziehung aus Gleichung (10) eingehalten, d.h. N ist gleich oder ein Vielfaches von $\hat{f}_s$ :

$$\hat{f}_S = \frac{f_S}{ggT(f_S, f_w)} , \qquad (10)$$

Die internen Register 421, 423, 431 und das erste Parameterregister 403 werden gelöscht. Das zweite Parameterregister 405 empfängt den Wert Eins. Dann wird sukzessive ein Eingangswert im Eingangsregister 401 gespeichert, der zu dem dritten internen Register 431 hinzuaddiert wird. Dann wird das erste interne Register 421 mit dem Produkt $Y \times S$, d.h. dem Produkt der Inhalte des Eingangsregisters 401 und des ersten Koeffizientenregisters 403, inkrementiert; das zweite interne Register 423 wird mit dem Produkt $Y \times C$, d.h. dem Produkt der Inhalte des Eingangsregisters 401 und des zweiten Koeffizientenregisters 405, inkrementiert. Zugleich wird das erste interne Register 421 entsprechend der Vorschrift $S \leftarrow dC \cdot S + dS \cdot C$ modifiziert und das zweite interne Register 423 entsprechend der Vorschrift $C \leftarrow dC \cdot C - dS \cdot S$ modifiziert. Hierbei bezeichnen $dS$ und $dC$ Konstanten mit den Werten:

$$dS = \sin(\Omega) , \qquad (19a)$$

$$dC = \cos(\Omega) , \qquad (19b)$$

mit

$$\Omega = 2\pi\sigma . \qquad (19c)$$

Der Zähler 429 wird verringert und nur wenn er gelöscht wird, werden die Inhalte der internen Register 421, 423, 431, d.h. die Werte

$$\frac{2}{N}SY , \frac{2}{N}CY , \frac{1}{N}\Sigma_Y$$

als U, V und $\beta$ in den jeweiligen Ausgangsregistern 407, 409, 413 gespeichert. U, V und $\beta$ können dann auch auf den Ausgangsdatenbus 419 übertragen werden.

Danach kann der Prozessor 400 durch Setzen des Reset-Signals 422 zurückgesetzt werden.

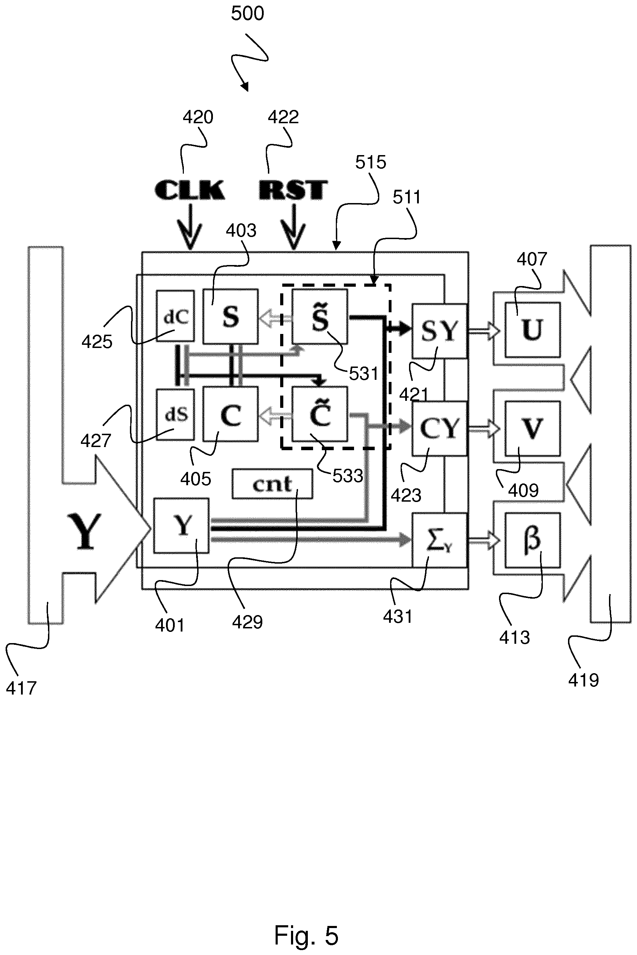

Fig. 5 zeigt eine schematische Darstellung eines Prozessors 500 zum Bestimmen einer Phase eines Empfangssignals gemäß einer dritten Ausführungsform.

Der Prozessor 500 entspricht dem Prozessor 400 bis darauf, dass er zwei zusätzliche interne Register aufweist, ein viertes internes Register 531 und ein fünftes internes Register 533. Entsprechend sind die Recheneinheit 511 und die Instruktionseinheit 515 zur Bearbeitung der damit verbundenen zusätzlichen Aufgaben anders ausgeführt.

Das vierte interne Register 531 und das fünfte interne Register 533 können dazu verwendet werden, Zwischenergebnisse bei der Bestimmung der Produkte $Y \times S$ und $Y \times C$ zu speichern. So kann das vierte interne Register 531 den Wert $\tilde{S} = dC \cdot S + dS \cdot C$ bestimmen, der dann verwendet werden kann, um das erste interne Register 421 entsprechend der Vorschrift $S \leftarrow dC \cdot S + dS \cdot C$ bzw. $S \leftarrow \tilde{S}$ zu modifizieren.

Das fünfte interne Register 533 kann den Wert $\tilde{C} = dC \cdot C - dS \cdot S$ bestimmen, der dann verwendet werden kann, um das zweite interne Register 423 entsprechend der Vorschrift $C \leftarrow dC \cdot C - dS \cdot S$ bzw. $C \leftarrow \tilde{C}$ zu modifizieren.

Der Prozessor 500 kann in Hardware oder in Software realisiert sein. Der Prozessor 500 kann eine Operationseinheit auf einem Chip bilden oder als Chip realisiert sein. Der Prozessor 500 kann ein digitaler Signalprozessor oder ein Mikrocontroller sein. Der Prozessor 500 kann als FPGA, als integrierte Schaltung, als ASIC oder als Teil dieser Bauelemente realisiert sein. Der Prozessor 500 kann in einem Empfänger oder als Teil einer Empfängerschaltung realisiert sein, beispielsweise einem Empfänger 103 wie in Figur 1 dargestellt.

Sowohl der Prozessor 300 gemäß der Beschreibung zu Figur 3 als auch die Prozessoren 400, 500 gemäß der Beschreibung zu den Figuren 4 und 5 eignen sich dazu, das in Fig. 2 beschriebene Verfahren 200 zu implementieren.

Ein Aspekt der Erfindung umfasst auch ein Computerprogrammprodukt, das direkt in den internen Speicher eines digitalen Computers geladen werden kann und Softwarecodeabschnitte umfasst, mit denen das zu Fig. 2 beschriebene Verfahren 200 ausgeführt werden kann, wenn das Produkt auf einem Computer läuft. Das Computerprogrammprodukt kann auf einem computergeeigneten Medium gespeichert sein und folgendes umfassen: computerlesbare Programmmittel, die einen Computer veranlassen, eine Empfangssequenz von mit bekannter Abtastfrequenz $f_S$ abgetasteten Werten eines Empfangssignals zu empfangen 201, wobei das Empfangssignal (Y) eine Reaktion auf ein Sendesignal mit einer bekannten Sendefrequenz $f_w$ darstellt; eine Sinussequenz und eine Kosinussequenz für jeden Index der Empfangssequenz bereitzustellen 202, die Sinussequenz umfassend Sinuswerte aufeinanderfolgender Vielfacher einer bekannten Kreisfrequenz $\Omega$, die von der Sendefrequenz $f_w$ und der Abtastfrequenz $f_s$ abhängt, und die Kosinussequenz umfassend Kosinuswerte aufeinanderfolgender Vielfacher der bekannten Kreisfrequenz; und einen Phasenrealteil des Empfangssignals basierend auf einem Skalarprodukt der Empfangssequenz mit der Kosinussequenz und einen Phasenimaginärteil des Empfangssignals basierend auf einem Skalarprodukt der Empfangssequenz mit der Sinussequenz zu bestimmen 203.

Der Computer kann ein PC sein, beispielsweise ein PC eines Computernetzwerks. Der Computer kann als ein Chip, ein ASIC, ein Mikroprozessor, ein Signalprozessor oder allgemein als ein Prozessor realisiert sein und beispielsweise als Prozessor wie in den Figuren 3 bis 5 beschrieben, implementiert sein.

Es ist selbstverständlich, dass die Merkmale der verschiedenen beispielhaft hierin beschriebenen Ausführungsformen miteinander kombiniert werden können, außer wenn spezifisch anderweitig angegeben. Wie in der Beschreibung und den Zeichnungen dargestellt, müssen einzelne Elemente, die in Verbindung stehend dargestellt wurden, nicht direkt miteinander in Verbindung stehen; Zwischenelemente können zwischen den verbundenen Elementen vorgesehen sein. Ferner ist es selbstverständlich, dass Ausführungsformen der Erfindung in einzelnen Schaltungen, teilweise integrierten Schaltungen oder vollständig integrierten Schaltungen oder Programmiermitteln implementiert sein können. Der Begriff "beispielsweise" ist lediglich als ein Beispiel gemeint und nicht als das Beste oder Optimale. Es wurden bestimmte Ausführungsformen hierin veranschaulicht und beschrieben, doch für den Fachmann ist es offensichtlich, dass eine Vielzahl von alternativen und/oder gleichartigen Implementierungen anstelle der gezeigten und beschriebenen Ausführungsformen verwirklicht werden können, ohne vom Konzept der vorliegenden Erfindung abzuweichen.

**Bezugszeichenliste**

| | |
|---|---|
| 100: | System 100 zur Messung von Phasenbeziehungen akustischer Wellen in einem Gefäß |
| 101: | Sender |
| 102: | Gefäß |
| 103: | Empfänger |
| 104: | Ultraschallwelle |
| 105: | Eingang |
| 107: | Ausgang |
| | |
| 200: | Phasendetektionsverfahren 200 |
| 201: | 1. Verfahrensschritt: Empfangen |
| 202: | 2. Verfahrensschritt: Bereitstellen |
| 203: | 3. Verfahrensschritt: Bestimmen |
| | |
| 300: | Prozessor, geeignet zum Bestimmen einer Phase eines Empfangssignals |

301: N-stufiges Eingangsregister
303: N-stufiges erstes Parameterregister
305: N-stufiges zweites Parameterregister
307: erstes Ausgangsregister
309: zweites Ausgangsregister
311: Recheneinheit
313: drittes Ausgangsregister
315: Instruktionseinheit
317: Eingangsdatenbus
319: Ausgangsdatenbus
320: Taktsignal
322: Reset-Signal

400: Prozessor, geeignet zum Bestimmen einer Phase eines Empfangssignals
401: Eingangsregister
403: erstes Parameterregister
405: zweites Parameterregister
407: erstes Ausgangsregister
409: zweites Ausgangsregister
411: Recheneinheit
413: drittes Ausgangsregister
415: Instruktionseinheit
417: Eingangsdatenbus
419: Ausgangsdatenbus
420: Taktsignal
422: Reset-Signal
421: erstes internes Register
423: zweites internes Register
431: drittes internes Register
425: drittes Parameterregister
427: viertes Parameterregister
429: Zähler

500: Prozessor, geeignet zum Bestimmen einer Phase eines Empfangssignals
511: Recheneinheit
515: Instruktionseinheit
531: viertes internes Register
533: fünftes internes Register

**Patentansprüche**

1. Prozessor (400, 500) zum Bestimmen einer Phase eines Empfangssignals, mit
einem Eingangsregister (401), das ausgelegt ist, einen Empfangswert eines mit bekannter Abtastfrequenz $f_S$ abgetasteten Empfangssignals (Y) zu speichern, wobei das Empfangssignal (Y) eine Reaktion auf ein Sendesignal mit einer bekannten Sendefrequenz $f_W$ darstellt;
**gekennzeichnet durch** ein erstes Koeffizientenregister (403) und ein zweites Koeffizientenregister (405), die ausgelegt sind, einen ersten (S) und einen zweiten (C) Fourier-Koeffizienten zu speichern, wobei der erste Fourier-Koeffizient (S) eine lineare Beziehung zwischen dem Empfangssignal (Y) und einem Phasenrealteil des Empfangssignals (Y) angibt und der zweite Fourier-Koeffizient (C) eine lineare Beziehung zwischen dem Empfangssignal (Y) und einem Phasenimaginärteil des Empfangssignals (Y) angibt;
ein erstes Ausgangsregister (407) und ein zweites Ausgangsregister (409), die ausgelegt sind, einen Phasenrealteil (U) und einen Phasenimaginärteil (V) des Empfangssignals (Y) bereitzustellen; und
eine Recheneinheit (411), die ausgelegt ist, den Phasenrealteil (U) des Empfangssignals (Y) basierend auf einem gemittelten Produkt des Empfangswertes mit dem Inhalt (S) des ersten Koeffizientenregisters (403) zu bestimmen und den Phasenimaginärteil (V) des Empfangssignals (Y) basierend auf einem gemittelten Produkt des Empfangswertes mit dem Inhalt (C) des zweiten Koeffizientenregisters (405) zu bestimmen.

**2.** Prozessor (400, 500) nach Anspruch 1, mit einer Instruktionseinheit (415), die ausgelegt ist,
ansprechend auf ein Reset-Signal (422) das zweite Koeffizientenregister (405) auf Eins zu setzen und die restlichen Register zu löschen;
ansprechend auf ein Takt-Signal (420) einen neuen Empfangswert des abgetasteten Empfangssignals (Y) zu speichern und das erste (403) und zweite (405) Koeffizientenregister mit neuen Koeffizienten (S, C) zu versorgen;
wobei die Recheneinheit (411) ausgelegt ist, die gemittelten Produkte basierend auf einer zeitlichen Mittelung der abhängig von dem Taktsignal (420) jeweils vorliegenden Produkte aus dem Empfangswert und dem Inhalt (S) des ersten Koeffizientenregisters (403) bzw. dem Inhalt (C) des zweiten Koeffizientenregisters (405) zu bestimmen;
wobei die Instruktionseinheit (415) ausgelegt ist, ansprechend auf das Takt-Signal (420) das zweite Koeffizientenregister (405) mit dem Koeffizienten $dC \cdot C - dS \cdot S$ zu erneuern und das erste Koeffizientenregister (403) mit dem Koeffizienten $dC \cdot S + dS \cdot C$ zu erneuern, wobei C den Inhalt des zweiten Koeffizientenregisters (405), S den Inhalt des ersten Koeffizientenregisters (403) angibt und ferner gilt: $dC = \cos(\Omega)$ und $dS = \sin(\Omega)$ mit $\Omega = 2\pi^*(f_W/f_S)$.

**3.** Prozessor (400, 500) nach Anspruch 2, mit
einem ersten (421) und zweiten (423) internen Register,
wobei die Instruktionseinheit (415) ausgelegt ist, ansprechend auf das Takt-Signal (420) das erste interne Register (421) mit einem Produkt aus dem Inhalt des Eingangsregisters (401) und dem Inhalt (S) des ersten Koeffizientenregisters (403) zu inkrementieren und das zweite interne Register (423) mit einem Produkt aus dem Inhalt des Eingangsregisters (401) und dem Inhalt (C) des zweiten Koeffizientenregisters (405) zu inkrementieren und jeweils mit einem Normierungsfaktor normiert in dem ersten (407) beziehungsweise zweiten (409) Ausgangsregister bereitzustellen.

**4.** Prozessor (400, 500) nach einem der Ansprüche 1 bis 3, mit
einem dritten Ausgangsregister (413), das ausgelegt ist, einen Bias ($\beta$) des Empfangssignals (Y) bereitzustellen,
wobei die Recheneinheit (411) ausgelegt ist, den Bias ($\beta$) des Empfangssignals (Y) basierend auf einer zeitlichen Mittelung des Inhalts des Eingangsregisters (401) zu bestimmen.

**Claims**

**1.** A processor (400, 500) for determining a phase of a receiving signal, comprising:

an input register (401), which is configured for storing a receiving value of a receiving signal (Y) sampled with a known sampling frequency $f_s$, said receiving signal (Y) representing a reaction to a transmitting signal having a known transmitting frequency $f_W$;
**characterized by**
a first coefficient register (403) and a second coefficient register (405), which are configured for storing a first Fourier coefficient (S) and a second Fourier coefficient (C), said first Fourier coefficient (S) denoting a linear relation between the receiving signal (Y) and a phase real part of the receiving signal (Y), and said second Fourier coefficient (C) denoting a linear relation between the receiving signal (Y) and a phase imaginary part of the receiving signal (Y);
a first output register (407) and a second output register (409), which are configured for providing a phase real part (U) and a phase imaginary part (V) of the receiving signal (Y); and
a computing unit (411), which is configured for determining the phase real part (U) of the receiving signal (Y) based on an averaged product of the receiving value with the content (S) of the first coefficient register (403) and for determining the phase imaginary part (V) of the receiving signal (Y) based on an averaged product of the receiving value with the content (C) of the second coefficient register (405).

**2.** The processor (400, 500) according to claim 1, comprising an instruction unit (415), which is configured
for resetting the second coefficient register (405) to one in response to a reset signal (422) and for deleting the remaining registers;
for storing a new receiving value of the sampled receiving signal (Y) in response to a clock signal (420) and for providing the first coefficient register (403) and the second coefficient register (405) with new coefficients (S, C);
wherein the computing unit (411) is configured for determining the averaged products based on a temporal averaging of products from the receiving value and the content (S) of the first coefficient register (403) or the content (C) of the second coefficient register (405), respectively, said products each being present in dependence of the clock signal (420);
wherein the instruction unit (415) is configured for renewing the second coefficient register (405) in response to the clock signal (420) using the coefficient $dC \cdot C - dS \cdot S$ and for renewing the first coefficient register (403) using the coefficient $dC \cdot S + dS \cdot C$, wherein C denotes the content of the second coefficient register (405), S denotes the content of the first coefficient register (403) and furthermore $dC = \cos(\Omega)$ and $dS = \sin(\Omega)$ with $\Omega = 2\pi^*(f_w/f_s)$ also apply.

3. The processor (400, 500) according to claim 2, comprising:

a first internal register (421) and a second internal register (423),
wherein the instruction unit (415) is configured for incrementing the first internal register (421) by a product from the content of the input register (401) and the content (S) of the first coefficient register (403) in response to the clock signal (420) and for incrementing the second internal register (423) by a product from the content of the input register (401) and the content (C) of the second coefficient register (405) and for providing each with a normalization factor normalized in the first output register (407) and the second output register (409), respectively.

4. The processor (400, 500) according to any one of the claims 1 to 3, comprising:

a third output register (413), which is configured for providing a bias ($\beta$) of the receiving signal (Y),
wherein the computing unit (411) is configured for determining the bias ($\beta$) of the receiving signal (Y) based on a temporal averaging of the content of the input register (401).

## Revendications

1. Processeur (400, 500) pour déterminer une phase d'un signal de réception, comprenant :

un registre d'entrée (401) qui est configuré pour stocker une valeur de réception d'un signal de réception (Y) échantillonné avec une fréquence d'échantillonnage $f_s$ connue, ledit signal de réception (Y) représentant une réaction à un signal de transmission ayant une fréquence de transmission $f_w$ connue ;
**caractérisé par**
un premier registre de coefficients (403) et un deuxième registre de coefficients (405), qui sont chacun configurés pour stocker un premier coefficient de Fourier (S) et un deuxième coefficient de Fourier (C), ledit premier coefficient de Fourier (S) désignant une relation linéaire entre le signal de réception (Y) et une partie réelle de phase du signal de réception (Y), et ledit deuxième coefficient de Fourier (C) désignant une relation linéaire entre le signal de réception (Y) et une partie imaginaire de phase du signal de réception (Y) ;
un premier registre de sortie (407) et un deuxième registre de sortie (409), qui sont chacun configurés pour mettre à disposition une partie réelle de phase (U) et une partie imaginaire de phase (V) du signal de réception (Y) ; et
une unité de compte (411), qui est configurée pour déterminer la partie réelle de phase (U) du signal de réception (Y) sur la base de la moyenne d'un produit de la valeur de réception avec le contenu (S) du premier registre de coefficients (403) et pour déterminer la partie imaginaire de phase (V) du signal de réception (Y) sur la base de la moyenne d'un produit de la valeur de réception avec le contenu (C) du deuxième registre de coefficients (405).

2. Processeur (400, 500) selon la revendication 1,
comprenant une unité d'instruction (415) qui est configurée
pour mettre le deuxième registre de coefficients (405) à la valeur un et pour supprimer les autres registres, en réponse à un signal de reset (422) ; et
pour stocker une nouvelle valeur de réception du signal de réception (Y) échantillonné et pour fournir de nouveaux coefficients (S, C) au premier registre de coefficients (403) et au deuxième registre de coefficients (405), en réponse à un signal d'horloge (420) ;
dans lequel l'unité de compte (411) est configurée pour déterminer les moyennes des produits sur la base d'une moyenne temporelle des produits de la valeur de réception avec le contenu (S) du premier registre de coefficients (403) ou avec le contenu (C) du deuxième registre de coefficients (405) respectivement, lesdits produits chacun étant présents en dépendance du signal d'horloge (420) ;
dans lequel l'unité d'instruction (415) est configurée pour renouveler le deuxième registre de coefficients (405) avec le coefficient $dC \cdot C - dS \cdot S$ et pour renouveler le premier registre de coefficients (403) avec le coefficient $dC \cdot S + dS \cdot C$, en réponse au signal d'horloge (420), C désignant le contenu du deuxième registre de coefficients (405), S désignant le contenu du premier registre de coefficients (403), et en outre il s'applique : $dC = \cos(\Omega)$ et $dS = \sin(\Omega)$ avec $\Omega = 2\pi^*(f_w/f_s)$.

**3.** Processeur (400, 500) selon la revendication 2, comprenant
un premier registre interne (421) et un deuxième registre interne (423),
dans lequel l'unité d'instruction (415) est configurée pour incrémenter le premier registre interne (421) avec un produit du contenu du registre d'entrée (401) et le contenu (S) du premier registre de coefficients (403) et pour incrémenter le deuxième registre interne (423) avec un produit du contenu du registre d'entrée (401) et le contenu (C) du deuxième registre de coefficients (405), en réponse au signal d'horloge (420), et pour mettre à disposition chacun desdits registres internes normalisés avec un facteur de normalisation dans le premier registre de sortie (407) ou dans le deuxième registre de sortie (409) respectivement.

**4.** Processeur (400, 500) selon l'une quelconque des revendications 1 à 3, comprenant :

un troisième registre de sortie (413), qui est configuré pour mettre à disposition un biais ($\beta$) du signal de réception (Y),
dans lequel l'unité de compte (411) est configurée pour déterminer le biais ($\beta$) du signal de réception (Y) sur la base d'une moyenne temporelle du contenu du registre d'entrée (401).

100

L

105

104

107

101

103

102

$\varphi_0$

$\varphi_0$

$\varphi_1$

Fig. 1

200

**201** — Empfangen einer Empfangssequenz

**202** — Bereitstellen einer Sinussequenz und einer Kosinussequenz

**203** — Bestimmen eines Phasenrealteils basierend auf einem Skalarprodukt der Empfangssequenz mit der Kosinussequenz und eines Phasenimaginärteils basierend auf einem Skalarprodukt der Empfangssequenz mit der Sinussequenz

Fig. 2

Fig. 3

Fig. 4

Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 5404388 A